# EUROPEAN PATENT SPECIFICATION

(11) **EP 2 186 352 B1**
(45) Date of publication and mention of the grant of the patent: **27.06.2012**
(21) Application number: 08741116.1
(22) Date of filing: 03.04.2008
(51) Int. Cl.: H04R 19/04

(54) **CONDENSER MICROPHONE USING THE CERAMIC PACKAGE WHOSE INSIDE IS ENCOMPASSED BY METAL OR CONDUCTIVE MATERIALS**
KONDENSATORMIKROFON MIT DER KERAMISCHEN KAPSELUNG, DEREN INNERES DURCH METALL ODER LEITFÄHIGE MATERIALIEN EINGESCHLOSSEN WIRD
MICROPHONE À CONDENSATEUR UTILISANT UN EMBALLAGE CÉRAMIQUE DONT L'INTÉRIEUR EST ENTOURÉ DE MÉTAL OU DE MATÉRIAUX CONDUCTEURS

(30) Priority: 03.09.2007 KR 20070088962
(43) Date of publication of application: 19.05.2010
(73) Proprietor: BSE Co., Ltd., Incheon 405-817 (KR)
(72) Inventor: PARK, Sung-Ho, Incheon 407-723 (KR); CHOO, Yun-Jai, Incheon 403-765 (KR)
(74) Representative: Käck, Jürgen
(86) International application number: PCT/KR2008/001866
(87) International publication number: WO 2009/031742

(56) References cited:
- EP-A2- 0 531 613
- WO-A1-2005/069682
- WO-A1-2006/023016
- WO-A1-2007/054070
- JP-A- 2007 043 327
- KR-B1- 100 740 463
- US-A1- 2004 202 345
- US-B2- 6 781 231

## Description

### Technical Field

The present invention relates to a condenser microphone, and more particularly, a condenser microphone using a ceramic package in which an inner wall is surrounded with a metallic or conductive material to ground electromagnetic waves, thereby reducing an electro static discharge (ESD) effect and an electro magnetic interference (EMI) effect.

### Background Art

Generally, a microphone refers to a converter for converting an acoustic energy into an electrical energy. The microphone is largely classified into an electrodynamic microphone and a condenser microphone.

The electrodynamic microphone uses an induced electromotive force. The electrodynamic microphone includes a coil connected to a magnet and a diaphragm that can generate a constant magnetic field inside a microphone, the coil moving within the magnetic field. The electrodynamic microphone measures the induced electromotive force generated when the coil vibrates due to vibration to convert the measured induced electromotive force into the electrical signal. Since the electrodynamic microphone has a mechanically strong characteristic, this can be advantage in poor surroundings. However, since the magnet must be provided within the microphone, miniaturization is difficult, sensitivity is inferior, and a response speed is slow.

The condenser microphone employs a principle of a condenser wherein two plate electrodes oppose each other. When one of the plate electrodes is used as a vibrating plate, the vibrating plate vibrates according to a sound to vary a capacitance of the condenser whereby an accumulated charge varies. Therefore, a current flows according to a variation of the sound. The condenser microphone is relatively easily miniaturized, the sensitivity is superior, and the response speed is fast.

A power must be supplied to one of the vibrating plate and the back plate to generate an electric field in order to manufacture the condenser microphone. The power is supplied to the back plate in a conventional condenser microphone. On the other hand, recently, a condenser microphone without requiring a separate power due to an electret accumulating the charge was developed.

The condenser microphone uses the electret continuingly accumulating the charge instead of a bias power to generate a static electric field. The condenser microphone using the electret refers to an electret condenser microphone (ECM).

A micro electro mechanical system (MEMS) technology is used for integration of a microdevice. The MEMS technology is a technology in which a micro sensor or an actuator that each has a diameter of m unit and an electrical-mechanical structure can be manufactured using a micro machining technique employing a semiconductor process, i.e., an integration circuit technique. The MEMS chip microphone manufactured using the micro machining technique can become miniaturization, high performance, multifunction, and integration through an ultra-precision micro machining, thereby improving stability and reliability.

Since the MEMS chip microphone manufactured using the micro machining technique is electrically driven and processes a signal, it is required that the MEMS chip microphone is packaged with a circuit part including different IC semiconductor chip devices. In case where the package is formed of ceramic, since the ceramic has non-conductivity, there is a limitation in an electric or acoustic aspect. Electromagnetic waves additionally generated from an electronic machine may have an effect on itself or other machines. This refers to an electro magnetic interference (EMI) effect Also, static electricity may be discharged from an object having static electricity. This refers to an electrostatic discharge (ESD) effect. The condenser microphone using the ceramic package has a limitation that the EMI effect and the ESD effect occur.

WO 2005/069682 A1 discloses a parallelepiped type condenser microphone for surface mounting. The condenser type microphone works with a diaphragm to transform the acoustic sound waves into an electrical signal using a polar ring as electrical conductor and a thi spacer. A metal case is one of the electrical connections from the diaphragm to encapsulated electronics provided on a PCB. The second electrical connection from the back plate to the PCB and the electronics thereon is provided via a conductive layer provided on an electrically insulating ring. So this diaphragm type of condenser microphone requires the case to be electrically conductive to provide the electrical signals from the diaphragm/back plate arranged at one side of the microphone case to the PCB at the opposing side within the case.

In WO 2006/023016 A1 a microphone constructed in MEMS technique is arranged in a space encapsulated by a substrate. The MEMS microphone and the electronics circuit are arranged on substrate. The case of the microphone is formed of a lower substrate, a sidewall substrate which is laterally surrounding in ring form the inner space of the microphone, and a cover substrate having a sound hole. The lower substrate, sidewall substrate and the cover substrate are formed in multi-layer construction, wherein electrically conductive layers are formed on the outer side such that the lower substrate, the ring shaped sidewall and the cover plate are electrically connected to each other. The cover plate and the plated sidewall of the ring shaped sidewall are electrically conductive so that they shield the inside of the microphone case.

It is an object of the invention to provide a condenser microphone and a manufacturing process for it in which the heat resistance during manufacturing when using SMD bonding processes is improved.

The invention is defined in the device claims 1 and 2 and the method claims 8 and 9, respectively.

Particular embodiments are set out in the dependent claims.

### Disclosure of Invention

The present invention provides a condenser microphone including, a substrate disposed on a micro electro mechanical system (MEMS) microphone chip and a circuit part: a package having a ring shape and disposed on the substrate, the package surrounding the MEMS microphone chip and the circuit part; an insertion part having a ring shape and formed of a conductive material, the insertion part being attached to an inner wall of the package; and an upper plate completely covering the package, the upper plate having an acoustic hole through which sound passes. Further elements are defined in claim 1.

In an alternative embodiment, a condenser microphone includes: a substrate disposed on a MEMS microphone chip and a circuit part; a package disposed on the substrate and covering the MEMS microphone chip and the circuit part, the package having an acoustic hole through which sound passes; and an insertion part attached to an inner wall of the package and formed of a conductive material, the insertion part having the acoustic hole through which the sound passes. Further elements are defined in claim 2.

According to the invention a method of manufacturing a condenser microphone includes: disposing a MEMS microphone chip and a circuit part on a substrate; disposing a package in which a conductive material is attached to an inner wall thereof on an upper portion of the substrate; and covering an upper plate having an acoustic hole through which sound passes on the package. Further elements are defined in claim 8.

Alternatively method of manufacturing a condenser microphone includes: disposing a MEMS microphone chip and a circuit part on a substrate; and disposing a package in which a conductive material is attached to an inner wall thereof and having an acoustic hole through which sound passes on an upper portion of the substrate. Further elements are defined in claim 9.

### Advantageous Effects

In the condenser microphone according to the present invention, the inner wall of the package surrounding the microphone chip and the circuit part or the upper plate of the package can be formed of the metallic or conductive material to improve the electric and acoustic characteristics of the condenser microphone package. Specifically, the EMI effect and the ESD effect can be reduced when compared to the case where the inner wall of the package and the upper plate of the package, which are formed of the ceramic, are used.

In addition, since the substrate is manufactured using the ceramic having heat-resistance and adapted to manufacture a surface mounted device (SMD), the deformation of degradation of the bonding characteristic during the thermal process can be prevented.

### Brief Description of the Drawings

FIG. 1 is a cross-sectional view of a condenser microphone using a ceramic package according to a first embodiment of the present invention.

FIG. 2 is an exploded perspective view of the condenser microphone using the ceramic package according to a first embodiment of the present invention.

FIG. 3 is a cross-sectional view of a condenser microphone using a ceramic package according to a second embodiment of the present invention.

FIG. 4 is an exploded perspective view of the condenser microphone using the ceramic package according to a second embodiment of the present invention.

### Mode for the Invention

Reference will now be made in detail to the preferred embodiments of the present invention, examples of which are illustrated in the accompanying drawings. The following embodiments are used only for explain a specific exemplary embodiment while not limiting the present invention.

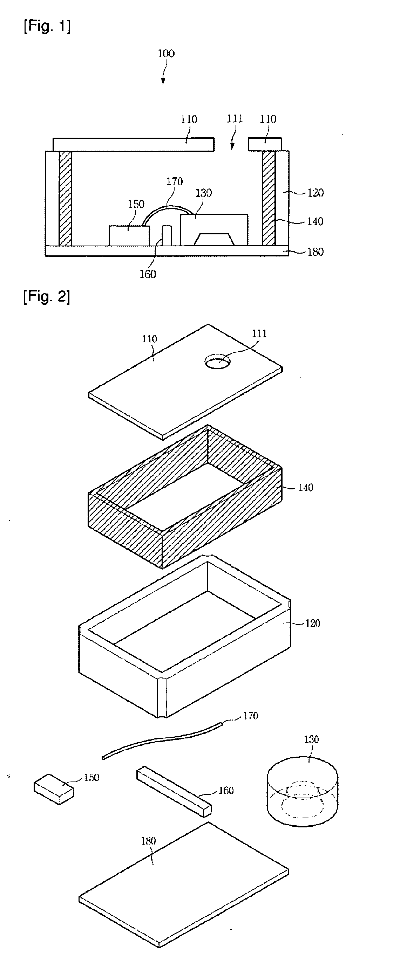

FIG. 1 is a cross-sectional view of a condenser microphone using a ceramic package according to a first embodiment of the present invention, and FIG. 2 is an exploded perspective view of the condenser microphone using the ceramic package according to a first embodiment of the present invention. Referring to FIGS. 1 and 2, a MEMS microphone chip 130 is packaged with a circuit part 150. The MEMS microphone chip 130 converts an acoustic source transmitted from the outside into an electrical signal. The signal is transmitted to the circuit part 150 along an electric wire 170. The circuit part 150 amplifies the electrical signal received by an IC chip therein to output the amplified signal into the outside.

The MEMS microphone chip 130 and the circuit part 150 are disposed on a substrate 180. The substrate is formed of ceramic. The ceramic has a heat-resistant, and a coefficient of thermal expansion similar to those of silicon and a metallic material constituting the MEMS microphone 130 and the circuit part 150 to prevent a deformation or degradation of a bonding characteristic during a thermal process.

The MEMS microphone chip 130 and the circuit part 150 are bonded to the substrate 180 by a die-bonding. An epoxy resin is used as adhesive used during the die-bonding. After the circuit part 150 is disposed on the substrate 180, the circuit part 150 is encapsulated with the epoxy resin to protect the circuit part 150. The adhesive such as the epoxy resin has a small viscosity and may spread out to an undesirable region. Thus, a projection 160 is disposed on the substrate 180 to prevent the epoxy resin from spreading out to the undesirable region.

The package 120 has a ring shape in which top and bottom surfaces are opened. The package 120 is formed of the ceramic. The ceramic has the heat-resistant, and the coefficient of thermal expansion similar to those of the silicon and the metallic material constituting the MEMS microphone 130 and the circuit part 150 to prevent the deformation or the degradation of the bonding characteristic during the thermal process.

An insertion part 140 having a ring shape in which top and bottom surfaces are opened is attached to an inner wall of the package 120. The insertion part 140 is formed of a metallic or conductive material. Since the metallic or conductive material conducts electricity in contrast to the ceramic that is a non-conductive material, electromagnetic waves generated from the MEMS microphone chip 130 is grounded. Thus, an EMI effect and an ESD effect are significantly reduced when compared to the case where the insertion part 140 is formed of only the non-conductive ceramic.

After the package 120 attaching the insertion part 140 is disposed on the substrate 180, an upper plate 110 covers an upper portion of the package 120. The upper plate 110 is in contact with the insertion part 140 along circumference of the insertion part 140. The upper plate 110 completely covers the package 120 to prevent sound within the package 120 from being leaked. An acoustic hole 111 is formed in the upper plate 110 in an upward direction of the MEMS microphone chip 130. The acoustic hole 111 receives the sound from the outside of the condenser microphone 100 to the inside of a package structure.

The upper plate 110 is formed of the metallic or conductive material, like the insertion part 140. In case where the upper plate 110 is formed of the metallic or conductive material, the electromagnetic waves generated from the MEMS microphone chip 130 is grounded to significantly reduce the EMI effect and the ESD effect when compared to the case where the insertion part 140 is formed of only the non-conductive ceramic. Thus, electric and acoustic characteristics of the condenser microphone package can be improved, like that of the package 120 formed of the metallic or conductive material.

In the condenser microphone 100, objects of the present invention can be achieved in case where the package 120 is closely attached to the insertion part 140 inserted into the inner wall of the package 120 as well as in case where the package 120 and the insertion part 140 are spaced a predetermined distance from each other. Since the package 120 and the substrate 180 are formed of the same material as the ceramic, the package 120 and the substrate 180 may be integrated in one body.

In the first embodiment, in case where the package 120 and the insertion part 140 are formed of the non-conductive material and integrated in one body, the electromagnetic waves generated from the condenser microphone can be grounded to reduce the EMI effect and the ESD effect.

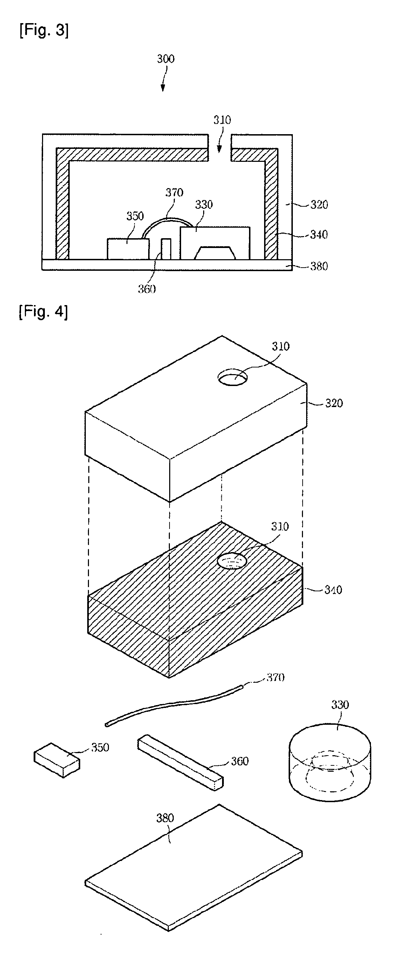

FIG. 3 is a cross-sectional view of a condenser microphone using a ceramic package according to a second embodiment of the present invention, and FIG. 4 is an exploded perspective view of the condenser microphone using the ceramic package according to a second embodiment of the present invention. Since the second embodiment has the substantially same structure and effect as the first embodiment, differences therebetween will be primarily described below.

In the second embodiment like that of the first embodiment, a MEMS microphone chip 330 and a circuit part 350 are attached to a substrate 380. A projection 360 is disposed on the substrate 380 to prevent epoxy resin from spreading out to an undesirable region.

Upper and lateral surfaces of a package 320 are closed, and only a bottom surface of the package 320 is opened. The package 320 is formed of ceramic. The ceramic has a heat-resistant, and a coefficient of thermal expansion similar to those of silicon and a metallic material constituting the MEMS microphone chip 330 and the circuit part 350 to prevent a deformation or degradation of a bonding characteristic during a thermal process.

An insertion part 340 in which upper and lateral surfaces are closed, and only a bottom surface, like the package 320, is opened is attached to an inner wall of the package 320. After the insertion part 340 and the package 320 are coupled, an acoustic hole 310 is formed in an upward direction of the MEMS microphone chip 330. The acoustic hole 111 receives sound from the outside of a condenser microphone 300. The insertion part 340 is formed of a metallic or conductive material. Thus, electromagnetic waves generated from the MEMS microphone chip 330 is grounded to significantly reduce an EMI effect and an ESD effect when compared to the case where the insertion part 340 is formed of only non-conductive ceramic.

After the insertion part 340 is attached to an inner wall of the package 320, the package 320 disposed on the substrate 380 is covered.

The above-described condenser microphone 300, the objects of the present invention can be achieved in case where the package 320 is closely attached to the insertion part 340 inserted into the inner wall of the package 320 as well as in case where the package 320 and the insertion part 340 are spaced a predetermined distance from each other. Also, since the package 320 and the substrate 380 are formed of the same material as the ceramic, the package 320 and the substrate 380 may be integrated in one body.

In the second embodiment, in case where the package 320 and the insertion part 340 are formed of the non-conductive material and integrated in one body, the electromagnetic waves generated from the condenser microphone can be grounded to reduce the EMI effect and the ESD effect.

It will be apparent to those skilled in the art that various modifications and variations can be made in the present invention. Thus, it is intended that the present invention covers the modifications and variations of this invention provided they come within the scope of the appended claims.

## Claims

1. A condenser microphone (100) comprising:
a substrate (180);
a micro electro mechanical system, i.e. MEMS microphone chip (130) and a circuit part (150) disposed on the substrate (180);
a package (120) disposed on the substrate (180), the package surrounding the MEMS microphone chip (130) and the circuit part (150);
an insertion part (140) formed of a conductive material, the insertion part being attached to an inner wall of the package; and
an upper plate (110) completely covering the package (120), the upper plate having an acoustic hole (111) through which sound passes;
**characterized in that**
the package (120) and the insertion part (140) have a ring shape;
the package (120) is formed of a ceramic material; and
the substrate (180) is formed of a ceramic material.

2. A condenser microphone (300) comprising:
a substrate (380);
a MEMS microphone chip (330) and a circuit part (350) disposed on the substrate (380);
a package (320) disposed on the substrate and covering the MEMS microphone chip and the circuit part, the package having an acoustic hole (310) through which sound passes; and
an insertion part (340) attached to an inner wall of the package (320) and formed of a conductive material, the insertion part having the acoustic hole (310) through which the sound passes;
**characterized in that**
the package (320) is formed of a ceramic material; and
the substrate (380) is formed of a ceramic material.

3. The condenser microphone of claim 1 or 2, wherein the insertion part (140, 340) is formed of a metallic material.

4. The condenser microphone of claim 1 or 2, further comprising a projection (160, 360) attached to an upper portion of the substrate (180, 380) to prevent epoxy resin from spreading out over a predetermined region.

5. The condenser microphone of claim 1 or 2, wherein the substrate (180, 380) and the package (140, 340) are integrated in one body.

6. The condenser microphone of any one of claims 1 to 5, wherein the package (120, 320) and the insertion part (140, 340) are spaced a predetermined distance from each other.

7. The condenser microphone of claim 1, wherein the upper plate (110) is formed of a conductive material.

8. A method of manufacturing a condenser microphone (100), the method comprising:
disposing a MEMS microphone chip (130) and a circuit part (150) on a substrate (180);
disposing a package (120) on an upper portion of the substrate (180), wherein a insertion part (140) formed of conductive material is attached to an inner wall of the package; and
covering an upper plate (110) having an acoustic hole (111) through which sound passes on the package;
**characterized in that**
the package (120) and the insertion part (140) have ring shape;
the package (120) is formed of a ceramic material; and
the substrate (180) is formed of a ceramic material.

9. A method of manufacturing a condenser microphone (300), the method compri sing:
disposing a MEMS microphone chip (330) and a circuit part (350) on a substrate (380); and
disposing a package (320) having an acoustic hole (310) through which sound passes on an upper portion of the substrate (380), wherein an insertion part (340) formed of conductive material is attached to an inner wall of the package;
**characterized in that**
the package (320) is formed of a ceramic material; and
the substrate (380) is formed of a ceramic material.

## Patentansprüche

1. Ein Kondensatormikrophon (100), das aufweist:
ein Substrat (180);
einen Mikrophonchip (130) eines mikroelektromechanischen Systems, d. h. eines MEMS, und ein Schaltungsteil (150), die auf dem Substrat (180) angeordnet sind;
ein Gehäuse (120), das auf dem Substrat (180) angeordnet ist, wobei das Gehäuse den MEMS-Mikrophonchip (130) und das Schaltungsteil (150) umgibt;
ein Einsatzteil (140), das aus einem leitfähigen Material ausgebildet ist, wobei das Einsatzteil an einer Innenwand des Gehäuses befestigt ist; und
eine obere Platte (110), die das Gehäuse (120) vollständig bedeckt, wobei die obere Platte ein Schallloch (111) aufweist, durch das Schall hindurchtritt;
**dadurch gekennzeichnet, dass**
das Gehäuse (120) und das Einsatzteil (140) eine Ringform aufweisen;
das Gehäuse (120) aus einem Keramikmaterial ausgebildet ist; und
das Substrat (180) aus einem Keramikmaterial ausgebildet ist.

2. Ein Kondensatormikrophon (300), das aufweist:
ein Substrat (380);
einen MEMS-Mikrophonchip (330) und ein Schaltungsteil (350), die auf dem Substrat (380) angeordnet sind;
ein Gehäuse (320), das auf dem Substrat angeordnet ist und den MEMS-Mikrophonchip und das Schaltungsteil bedeckt, wobei das Gehäuse ein Schallloch (310) aufweist, durch das Schall hindurchtritt; und
ein Einsatzteil (340), das an einer Innenwand des Gehäuses (320) befestigt ist und aus einem leitfähigen Material ausgebildet ist, wobei das Einsatzteil das Schallloch (310) aufweist, durch das der Schall hindurchtritt,
**dadurch gekennzeichnet, dass**
das Gehäuse (320) aus einem Keramikmaterial ausgebildet ist; und
das Substrat (380) aus einem Keramikmaterial ausgebildet ist.

3. Das Kondensatormikrophon nach Anspruch 1 oder 2, wobei das Einsatzteil (140, 340) aus einem metallischen Material ausgebildet ist.

4. Das Kondensatormikrophon nach Anspruch 1 oder 2, das ferner einen Vorsprung (160, 360) aufweist, der an einem oberen Abschnitt des Substrats (180, 380) befestigt ist, um zu verhindern, dass sich Epoxidharz über einen vorbestimmten Bereich ausbreitet.

5. Das Kondensatormikrophon nach Anspruch 1 oder 2, wobei das Substrat (180, 380) und das Gehäuse (140, 340) in einem Körper integriert sind.

6. Das Kondensatormikrophon nach einem der Ansprüche 1 bis 5, wobei das Gehäuse (120, 320) und das Einsatzteil (140, 340) um einen vorbestimmten Abstand voneinander beabstandet sind.

7. Das Kondensatormikrophon nach Anspruch 1, wobei die obere Platte (110) aus einem leitfähigen Material ausgebildet ist.

8. Ein Verfahren zur Herstellung eines Kondensatormikrophons (100), wobei das Verfahren aufweist:
Anordnen eines MEMS-Mikrophonchips (130) und eines Schaltungsteils (150) auf einem Substrat (180);
Anordnen eines Gehäuses (120) auf einem oberen Abschnitt des Substrats (180), wobei ein Einsatzteil (140), das aus leitfähigem Material ausgebildet ist, an einer Innenwand des Gehäuses befestigt ist; und
Abdecken des Gehäuses mit einer oberen Platte (110) mit einem Schallloch (111), durch das Schall hindurchtritt;
**dadurch gekennzeichnet, dass**
das Gehäuse (120) und das Einsatzteil (140) eine Ringform aufweisen;
das Gehäuse (120) aus einem Keramikmaterial ausgebildet ist; und
das Substrat (180) aus einem Keramikmaterial ausgebildet ist.

9. Ein Verfahren zur Herstellung eines Kondensatormikrophons (300), wobei das Verfahren aufweist:
Anordnen eines MEMS-Mikrophonchips (330) und eines Schaltungsteils (350) auf einem Substrat (380); und
Anordnen eines Gehäuses (320) mit einem Schallloch (310), durch das Schall hindurchtritt, auf einem oberen Abschnitt des Substrats (380), wobei ein Einsatzteil (340), das aus leitfähigem Material ausgebildet ist, an einer Innenwand des Gehäuses befestigt ist;
**dadurch gekennzeichnet, dass**
das Gehäuse (320) aus einem Keramikmaterial ausgebildet ist; und
das Substrat (380) aus einem Keramikmaterial ausgebildet ist.

## Revendications

1. Microphone à condensateur (100) comprenant :
un substrat (180) ;
un microsystème électromécanique, par exemple une puce microphone MEMS (130), et une partie de circuit (150) disposée sur le substrat (180) ;
un boîtier (120) disposé sur le substrat (180), lequel boîtier entoure la puce microphone MEMS (130) et la partie de circuit (150) ;
une pièce d'insertion (140) formée d'un matériau conducteur, laquelle pièce d'insertion est attachée à une paroi intérieure du boîtier ; et
une plaque supérieure (110) recouvrant complètement le boîtier (120), laquelle plaque supérieure a un trou acoustique (111) à travers lequel passe le son ;
**caractérisé en ce que**
le boîtier (120) et la pièce d'insertion (140) ont une forme annulaire ;
le boîtier (120) est formé d'un matériau céramique ; et
le substrat (180) est formé d'un matériau céramique.

2. Microphone à condensateur (300) comprenant :
un substrat (380) ;
une puce microphone MEMS (330) et une partie de circuit (350) disposée sur le substrat (380) ;
un boîtier (320) disposé sur le substrat et recouvrant la puce microphone MEMS et la partie de circuit, lequel boîtier a un trou acoustique (310) à travers lequel passe le son ; et
une pièce d'insertion (340) attachée à une paroi intérieure du boîtier (320) et formée d'un matériau conducteur, laquelle pièce d'insertion a un trou acoustique (310) à travers lequel passe le son ;
**caractérisé en ce que**
le boîtier (320) est formé d'un matériau céramique ; et
le substrat (380) est formé d'un matériau céramique.

3. Microphone à condensateur selon la revendication 1 ou 2, dans lequel la pièce d'insertion (140, 340) est formée d'un matériau métallique.

4. Microphone à condensateur selon la revendication 1 ou 2, comprenant en outre une saillie (160, 360) attachée à une portion supérieure du substrat (180, 380) pour empêcher la résine époxy de s'étendre sur une région prédéterminée.

5. Microphone à condensateur selon la revendication 1 ou 2, dans lequel le substrat (180, 380) et le boîtier (140, 340) sont intégrés en un seul corps.

6. Microphone à condensateur selon une quelconque des revendications 1 à 5, dans lequel le boîtier (120, 320) et la pièce d'insertion (140, 340) sont espacés l'un de l'autre d'une distance prédéterminée.

7. Microphone à condensateur selon la revendication 1, dans lequel la plaque supérieure (110) est formée d'un matériau conducteur.

8. Procédé de fabrication d'un microphone à condensateur (100), lequel procédé comprend :
disposition d'une puce microphone MEMS (130) et d'une partie de circuit (150) sur un substrat (180) ;
disposition d'un boîtier (120) sur une portion supérieure du substrat (180), une pièce d'insertion (140) formée d'un matériau conducteur étant attachée à une paroi intérieure du boîtier ; et
recouvrement du boîtier avec une plaque supérieure (110) ayant un trou acoustique (111) à travers lequel passe le son ;
**caractérisé en ce que**
le boîtier (120) et la pièce d'insertion (140) ont une forme annulaire ;
le boîtier (120) est formé d'un matériau céramique ; et
le substrat (180) est formé d'un matériau céramique.

9. Procédé de fabrication d'un microphone à condensateur (300), lequel procédé comprend :
disposition d'une puce microphone MEMS (330) et d'une partie de circuit (350) sur un substrat (380) ; et
disposition d'un boîtier (320) ayant un trou acoustique (310) à travers lequel passe le son sur une portion supérieure du substrat (380), une pièce d'insertion (340) formée d'un matériau conducteur étant attachée à une paroi intérieure du boîtier ;
**caractérisé en ce que**
le boîtier (320) est formé d'un matériau céramique ; et
le substrat (380) est formé d'un matériau céramique.
